**Europäisches Patentamt**

**European Patent Office**

**Office européen des brevets**

(19)

(11) Veröffentlichungsnummer : **0 025 579**
**B1**

(12) **EUROPÄISCHE PATENTSCHRIFT**

(45) Veröffentlichungstag der Patentschrift :
**07.12.83**

(51) Int. Cl.³ : **H 01 J 29/70, H 01 J 37/30**

(21) Anmeldenummer : **80105370.3**

(22) Anmeldetag : **08.09.80**

(54) **Verfahren und Vorrichtung zur schnellen Ablenkung eines Korpuskularstrahles.**

(30) Priorität : **13.09.79 DE 2937136**

(43) Veröffentlichungstag der Anmeldung :
**25.03.81 Patentblatt 81/12**

(45) Bekanntmachung des Hinweises auf die Patenterteilung : **07.12.83 Patentblatt 83/49**

(84) Benannte Vertragsstaaten :
**FR GB NL**

(56) Entgegenhaltungen :
**DE-A- 2 427 866**
**DE-A- 2 502 431**
**US-A- 2 623 196**
**US-A- 3 668 462**
**IBM JOURNAL OF RESEARCH AND DEVELOPMENT, Vol. 21, No. 6, November 1977, New York DAVIS, MOORE, WILLIAMS, WOODART "Automatic Registration in an Electron-Beam Lithographic System" Seiten 498-505**

(73) Patentinhaber : **SIEMENS AKTIENGESELLSCHAFT**
**Berlin und München Wittelsbacherplatz 2**
**D-8000 München 2 (DE)**

(72) Erfinder : **Anger, Klaus, Dipl.-Ing.**
**Milowstrasse 2**
**D-1000 Berlin 33 (DE)**
Erfinder : **Froslen, Jürgen, Dipl.-Ing.**
**Tile Brügge Weg 40**
**D-1000 Berlin 27 (DE)**

EP 0 025 579 B1

Jouve, 18, rue St-Denis, 75001 Paris, France

## Verfahren und Vorrichtung zur schnellen Ablenkung eines Korpuskularstrahles

Die Erfindung betrifft ein Verfahren zur Ablenkung eines Korpuskularstrahles in einem korpuskularstrahloptischen Gerät, insbesondere einem Elektronenstrahlschreiber, wobei für die Ablenkung eine elektrostatische und eine magnetische Ablenkeinrichtung und in Strahlrichtung hintereinanderliegend angeordnet sind. Weiterhin betrifft die Erfindung eine Vorrichtung zur Durchführung dieses Verfahrens.

Die lithografische Erzeugung feiner Strukturen erfolgt heutzutage in Geräten, in denen ein feiner oder aber bereits geformter Korpuskularstrahl — vornehmlich ein Elektronenstrahl — über ein zu strukturierendes Target geführt wird. Zur wirtschaftlichen Anwendung derartiger Verfahren ist eine sehr schnelle Ablenkung des Schreibstrahles mit Frequenzen bis zu 100 MHz unerläßlich. Bei bekannten rein magnetischen ein- oder zweistufigen Ablenksystemen besteht bei so hohen Ablenkgeschwindigkeiten das Problem, entsprechend schnelle Ablenkverstärker zu bauen, die in der Lage sind, die Ablenkströme in der geforderten Geschwindigkeit zu ändern.

Rein elektrostatische Ablenksysteme arbeiten zwar schnell, doch besitzen sie größere Ablenkfehler — insbesondere Farbfehler — und sind daher für eine Strukturerzeugung über große Bildfelder ungeeignet.

Aus der Veröffentlichung DE-A-2 502 431 ist eine Vorrichtung zum Ablenken eines Korpuskularstrahles durch eine magnetische und eine elektrostatische Ablenkeinrichtung bekannt. Die magnetische und die elektrostatische Ablenkeinrichtung sind dabei in Strahlrichtung hintereinander angeordnet. In dieser Veröffentlichung werden ein Verfahren und eine Vorrichtung angegeben, mit denen auch umfangreichere Muster durch genaue Aneinanderreihung mehrerer Teilbereiche auf ein Target aufgebracht werden können.

Es ist bereits ein zweistufiges kombiniertes Ablenksystem mit einer elektrostatischen Ablenkeinrichtung und einer in Strahlrichtung dahinterliegenden magnetischen Ablenkeinrichtung bekannt. Bei diesem System wird mit Hilfe der magnetischen Ablenkeinrichtung eine langsame Ablenkung großer Amplitude vorgenommen, mit Hilfe der elektrostatischen Ablenkeinrichtung eine schnelle Ablenkung kleiner Amplitude. Beide Ablenkeinrichtungen werden dazu mit unterschiedlichen Signalen angesteuert. Es besteht daher nicht die Möglichkeit, neben den geometrischen Fehlern auch die außer-axialen Farbfehler zu beseitigen. Durch eine Überlagerung dieses Ablenksystems mit einer Projektionslinse (J. L. Mauer, H. C. Pfeiffer, W. Stickel, « International electron devices meeting », Dez. 1976, Washington, Seiten 434-436) werden die Farbfehler etwas reduziert, jedoch nicht vollständig beseitigt.

Der vorliegenden Erfindung liegt daher die Aufgabe zugrunde, ein Verfahren und eine entsprechende Vorrichtung anzugeben, bei dem alleine dadurch und auch ohne zusätzliche Einrichtungen die außeraxialen Farbfehler weitestgehend kompensiert werden.

Diese Aufgabe wird bei einem Verfahren der eingangs genannten Art erfindungsgemäß durch die im kennzeichnenden Teil des Anspruches 1 angegebenen Merkmale gelöst. Dem erfindungsgemäßen Verfahren liegt der Gedanke zugrunde, daß der außeraxiale Farbfehler für die magnetische und die elektrostatische Ablenkung unterschiedlich groß ist. Für eine magnetische Ablenkung ergibt sich für den außeraxialen Farbfehler im Achsabstand $w_m$ des Korpuskularstrahles in der Bildebene

$$\Delta w_m = 1/2 \cdot \Delta U/U \cdot w_m.$$

Entsprechend ergibt sich für eine elektrostatische Ablenkung $\Delta w_e = - \Delta U/U \cdot w_e$. Dabei bedeuten $w_m$ bzw. $w_e$ die Achsabstände für die entsprechenden Ablenkungen in der Bildebene für den Fall, daß der Abstand des magnetischen Ablenksystems zur Bildebene gleich dem Abstand des elektrostatischen Ablenksystems zur Bildebene wäre; $\Delta U/U$ ist ein Maß für die Energiebreite des Korpuskularstrahles. Wie man aus diesen Gleichungen ersieht, besitzen die außeraxialen Farbfehler für die magnetische bzw. elektrostatische Ablenkung gleiches Vorzeichen. Außerdem ist der Fehler für die magnetische Ablenkung halb so groß wie der für die elektrostatische. Eine achromatische Ablenkung läßt sich daher erreichen, wenn die beiden Farbfehler betragsmäßig gleich groß sind. Das ist erfüllt, wenn die magnetische Ablenkung doppelt so groß und entgegengesetzt zur elektrostatischen Ablenkung verläuft. d. h. wenn der magnetische Ablenkwinkel doppelt so groß ist wie der elektrostatische Ablenkwinkel.

Erfindungsgemäß wird daher im Gegensatz zu dem bekannten kombinierten Ablenksystem die magnetische und die elektrostatische Ablenkeinrichtung mit gleicher Frequenz angesteuert. Dadurch wird zunächst eine langsame Ablenkung über einen großen Bereich ermöglicht. Entsprechende Ablenkverstärker für die Stromversorgung der magnetischen Ablenkeinrichtung sind einfach zu verwirklichen. Für schnelle kleine Ablenkungen wird zusätzlich allein die elektrostatische Ablenkeinrichtung schnell angesteuert. Da es sich hierbei nur um vergleichsweise kleine Ablenkamplituden handelt, bleibt die Korrektur der außeraxialen Farbfehler weitgehend erhalten.

Bei der Herstellung hochintegrierter Schaltkreise werden die Halbleiterscheiben mit einem elektronenempfindlichen Lack beschichtet und anschließend in einem Elektronenstrahlschreiber belichtet. Je nach der verwendeten Lacksorte ist für eine ausreichende Belichtung eine bestimmte Verweildauer der Elektronenstrahlsonde an einer Stelle nötig. Nach dieser Zeit wird die Sonde sprungartig zum benachbarten Bereich geführt, um auch diesen zu belichten. Die Ablenkkurve für einen solchen Vorgang entspricht einer Treppenkurve, wobei die Breite der einzelnen Treppenstufen der Verweildauer entspricht und die Höhe der einzelnen Treppenstufen der Sprungweite. Zur Realisierung einer derartigen Kurve ist in Weiterbildung des erfindungsgemäßen Verfahrens vorgesehen, daß die aus der Ansteuerung mit der Frequenz $f_1$ resultierende Ablenkgeschwindigkeit entgegengesetzt gleich der durch die zusätzliche elektrostatische Ablenkung mit der Frequenz $f_2$ bewirkte Ablenkgeschwindigkeit ist.

Eine vorteilhafte Vorrichtung zur Durchführung des erfindungsgemäßen Verfahrens ergibt sich bei einem Ablenksystem, bei dem die magnetische Ablenkeinrichtung aus Magnetspulen und die elektrostatische aus Kondensatoren besteht, aus den kennzeichnenden Merkmalen des Anspruches 3.

Um neben den außeraxialen Farbfehlern zusätzlich die geometrischen Ablenkfehler zu reduzieren, sind die beiden Ablenkeinrichtungen etwas aus der gekreuzten Stellung herausgedreht.

Anhand von sieben Figuren werden im folgenden zwei Ausführungsbeispiele der Erfindung näher beschrieben und erläutert. Dabei zeigt

Figur 1 in einer prinzipiellen Darstellung zwei mögliche Ausführungsformen einer Vorrichtung zur erfindungsgemäßen schnellen und farbfehlerfreien Ablenkung.

Figuren 2 bis 7 zeigen eine mögliche zeitabhängige Ansteuerung der Ablenkeinrichtung und die daraus resultierenden Ablenkkurven.

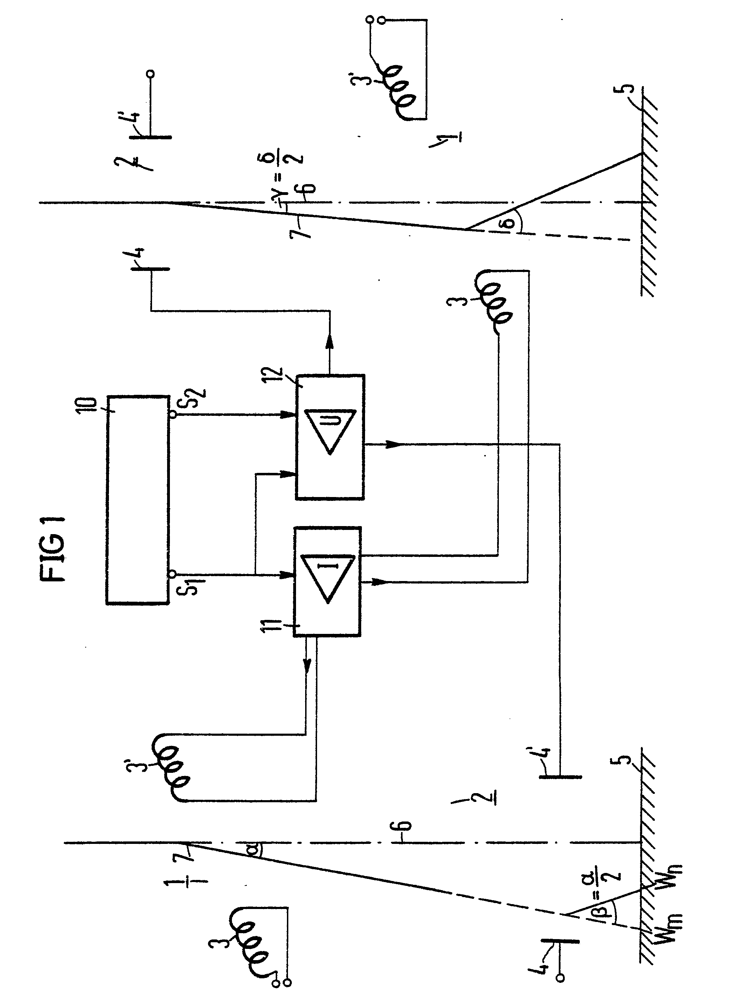

Im linken Teil der Fig. 1 ist in perspektivischer Darstellung ein kombiniertes gekreuztes Ablenksystem mit einer magnetischen Ablenkeinrichtung 1 und einer elektrostatischen Ablenkeinrichtung 2 dargestellt. Das magnetische Ablenksystem besteht aus zwei Magnetspulen 3 bzw. 3'. Das elektrostatische Ablenksystem besteht aus den Kondensatorplatten 4 bzw. 4'. Unterhalb dieses Ablenksystems befindet sich ein zu belichtendes Target 5. Mit 6 ist die Achse des hier nicht näher dargestellten Elektronenstrahlschreibers bezeichnet. Die Felder der beiden Ablenkeinrichtungen 1 bzw. 2 stehen senkrecht aufeinander.

Beim Durchlaufen des magnetischen Ablenksystems 1 wird der Elektronenstrahl 7 um einen bestimmten Winkel $\alpha$ von der Achse 6 weggelenkt. Ohne das in Strahlrichtung folgende elektrostatische Ablenksystem 2 würde der so abgelenkte Strahl, wie durch die gestrichelte Linie angedeutet, das Target 5 in einem Abstand $w_m$ treffen.

Durch das elektrostatische Ablenksystem 2 wird jedoch der Elektronenstrahl 7 wieder um einen Winkel $\beta$ zur Achse hin zurückgelenkt, so daß der Elektronenstrahl 7 das Target 5 in einem Achsabstand $w_n$ trifft.

Im rechten Teil der Fig. 1 ist ein Ausführungsbeispiel dargestellt, bei dem die Lage der beiden Ablenkeinrichtungen in Strahlrichtung vertauscht ist, d. h. in Strahlrichtung kommt zuerst das elektrostatische Ablenksystem 2 und anschließend das magnetische Ablenksystem 1. Hierbei wird der Elektronenstrahl zunächst um den Winkel $\gamma$ in einer Richtung und anschließend um den Winkel $\delta$ in entgegensetzter Richtung abgelenkt. Am Prinzip ändert sich dadurch nichts. Gleiche Teile sind mit gleichen Bezugszeichen versehen.

In der Mitte der Fig. 1 ist für beide Ausführungsbeispiele gemeinsam die Ansteuerung schematisch dargestellt. Ein Funktionsgenerator 10 liefert ein langsames Steuersignal $S_1$ mit der Frequenz $f_1$. Dieses Signal steuert gleichzeitig einen Stromverstärker 11 und einen Spannungsverstärker 12 an. Über den Stromverstärker 11 wird der Ablenkstrom durch die Magnetspulen 2 bzw. 3' entsprechend der Steuerfunktion $S_1$ geändert. In gleicher Weise und synchron dazu wird über den Spannungsverstärker 12 die Spannung an den Kondensatorplatten 4 bzw. 4' geändert. Durch diese Ansteuerung ist die farbfehlerfreie langsame Ablenkung des Elektronenstrahles, wie sie in der linken und rechten Hälfte der Fig. 1 dargestellt ist, sichergestellt.

Der Funktionsgenerator 10 liefert weiter ein Ausgangssignal $S_2$ mit der hohen Frequenz $f_2$. Dieses Signal steuert lediglich zusätzlich den Spannungsverstärker 12 an, wodurch der an den Kondensatorplatten 4 bzw. 4' anliegenden und sich langsam verändernden Ablenkspannung eine sich mit hoher Frequenz verändernde Ablenkspannung überlagert wird.

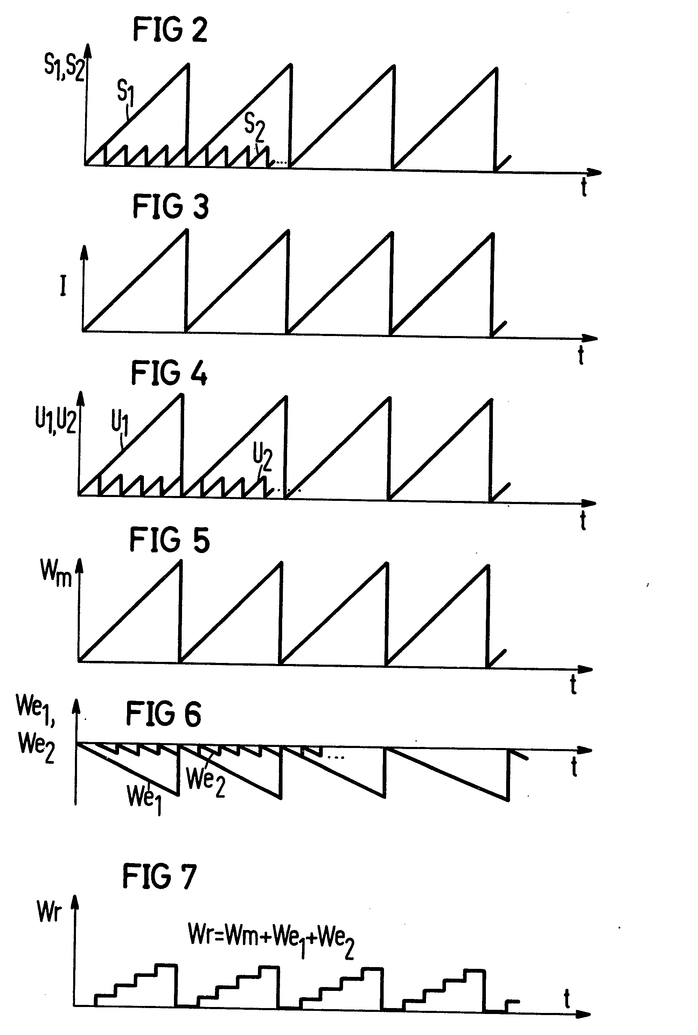

In der Fig. 2 sind beispielhaft die Steuersignale $S_1$ und $S_2$ des Funktionsgenerators 10 über der Zeit t aufgetragen. In diesem Beispiel unterscheiden sich die beiden Steuersignale in ihrer Frequenz lediglich um einen Faktor 5. In der Praxis wird der Frequenzunterschied wesentlich höher liegen. Ebenso wird es sich mit den Amplituden der Steuersignale verhalten.

In Fig. 3 ist im gleichen Zeitmaßstab der Ablenkstrom I aufgetragen. In Fig. 4 sind entsprechend die aus den Steuersignalen $S_1$ und $S_2$ resultierenden Ablenkspannungen $U_1$ bzw. $U_2$ aufgetragen. Die Fig. 5 und 6 zeigen wiederum im gleichen Zeitmaßstab die magnetisch bedingte sowie die elektrostatisch bedingte Ablenkung $w_m$ bzw. $w_{e1}$, $w_{e2}$. Die abschließende Fig. 7 zeigt die sich aus der magnetischen und elektrostatischen Ablenkung ergebende resultierende Ablenkung $w_r$ auf dem Target. Durch Änderung der Frequenzen und der Amplituden der Steuersignale $S_1$ und $S_2$ läßt sich die Treppenkurve und damit die Sprungweite der Sonde und die Belichtungszeit leicht variieren.

Eine weitere Möglichkeit der Ansteuerung und der Ablenkung des Elektronenstrahls wäre beispielsweise, daß die langsame Ablenkung in großen Treppenstufen vor sich geht, denen sich die schnelle Ablenkung mit kleinen Treppenstufen überlagert, so daß die resultierende Ablenkung wiederum eine Treppenkurve entsprechend der Fig. 7 darstellt.

In den Ausführungsbeispielen wurde die Ablenkung eines Elektronenstrahles beschrieben. Ebenso ist es möglich, einen Ionenstrahl abzulenken, mit dem beispielsweise in einem Ionenstrahlgerät der Lack auf dem Target in den belichteten Bereichen weggeätzt werden kann.

Die Ausführungsbeispiele zeigen die Ablenkung in einer Koordinate. Für die dazu senkrechte Koordinate müssen weitere, um 90° gedrehte Ablenksysteme vorgesehen sein.

**Ansprüche**

1. Verfahren zur Ablenkung eines Korpuskularstrahles in einem korpuskularstrahloptischen Gerät, insbesondere in einem Elektronenstrahlschreiber, wobei für die Ablenkung eine elektrostatische und eine magnetische Ablenkeinrichtung in Strahlrichtung hintereinanderliegend angeordnet sind, dadurch gekennzeichnet, daß beide Ablenkeinrichtungen (1, 2) gleichzeitig mit einer ersten Frequenz ($f_1$) derart angesteuert werden, daß in der Bildebene die elektrostatische Ablenkung des Korpuskularstrahles (7) in entgegengesetzter Richtung zur magnetischen Ablenkung bei halb so großer elektrostatischer Ablenkung wie bei der magnetischen Ablenkung erfolgt.

2. Verfahren zur Ablenkung eines Korpuskularstrahles nach Anspruch 1, dadurch gekennzeichnet, daß die elektrostatische Ablenkeinrichtung (2) zusätzlich mit einer höheren Frequenz $f_2$ ($f_2 > f_1$) angesteuert wird, deren Amplitude kleiner ist als die Amplitude der Ablenkung mit der Frequenz $f_1$.

3. Verfahren zur Ablenkung eines Korpuskularstrahles nach Anspruch 2, dadurch gekennzeichnet, daß die aus der Ansteuerung mit der Frequenz $f_1$ resultierende Ablenkgeschwindigkeit entgegengesetzt gleich der durch die zusätzliche elektrostatische Ablenkung mit der Frequenz $f_2$ bewirkten Ablenkgeschwindigkeit ist.

4. Vorrichtung zur Durchführung des Verfahrens nach einem der Ansprüche 2 oder 3 mit Ablenkspulen als magnetische Ablenkeinrichtung und Kondensatorplatten als elektrostatische Ablenkeinrichtung, dadurch gekennzeichnet, daß die Ablenkspulen (3, 3') an einen Stromverstärker (11) und die Kondensatorplatten (4, 4') an einen Spannungsverstärker (12) angeschlossen sind, daß beide Verstärker (11, 12) gemeinsam an einen Ausgang für die Frequenz $f_1$ eines Steuergliedes (10) angeschlossen sind und daß der Spannungsverstärker (12) noch mit einem weiteren Ausgang für die Frequenz $f_2$ des Steuergliedes (10) verbunden ist.

5. Vorrichtung nach Anspruch 4, dadurch gekennzeichnet, daß für jede Koordinate die Felder der beiden Ablenkeinrichtungen (1, 2) nicht genau senkrecht aufeinander stehen.

**Claims**

1. A process for deflecting a corpuscular beam in corpuscular radiation-optical apparatus, in particular in an electron beam printer, where an electrostatic and a magnetic deflecting device are consecutively arranged in the direction of radiation for the deflection, characterised in that both deflecting devices (1, 2) are simultaneously controlled with a first frequency ($f_1$) in such a manner that in the image plane the electrostatic deflection of the corpuscular beam (7) is effected in the opposite direction to the magnetic deflection with a deflection half as large as that for the magnetic deflection.

2. A process for deflecting a corpuscular beam as claimed in Claim 1, characterised in that the electrostatic deflecting device (2) is additionally controlled with a higher frequency $f_2$ ($f_2 > f_1$), whose amplitude is smaller than the amplitude of the deflection with the frequency $f_1$.

3. A process for deflecting a corpuscular beam as claimed in Claim 2, characterised in that the deflecting velocity resulting from the control with the frequency $f_1$ is equal but opposite to the deflecting velocity effected by the additional electrostatic deflection with the frequency $f_2$.

4. A device for implementing the process as claimed in one of Claims 2 or 3 having deflecting coils as a magnetic deflecting device and capacitor plates as an electrostatic deflecting device, characterised in that the deflecting coils (3, 3') are connected to a current amplifier (11) and the capacitor plates (4, 4') are connected to a voltage amplifier (12), that both amplifiers (11, 12) are commonly connected to an output of a control element (10) for the frequency $f_1$, and that the voltage amplifier (12) is also connected to a further output of the control element (10) for the frequency $f_2$.

5. A device as claimed in Claim 4, characterised in that the fields of the two deflecting devices (1, 2) are not exactly at right angles to one another for each coordinate.

**Revendications**

1. Procédé pour dévier un faisceau corpusculaire dans un appareil optique à faisceau corpusculaire, plus particulièrement dans un dispositif traceur à faisceau électronique, du type dans lequel, pour la déviation, un dispositif de déviation électrostatique et un dispositif de déviation magnétique sont disposés l'un derrière l'autre dans la direction du faisceau, caractérisé par le fait que les deux dispositifs de déviation (1, 2) sont attaqués simultanément et de telle façon avec une première fréquence ($f_1$) que dans le plan image la déviation électrostatique du faisceau corpusculaire (7) a lieu en direction opposée par rapport à la déviation magnétique, pour une déviation électrostatique qui est égale à la moitié de la déviation magnétique.

2. Procédé pour dévier un faisceau corpusculaire selon la revendication 1, caractérisé par le fait que le dispositif de déviation électrostatique (2) est de plus attaqué avec une fréquence plus

élevée $f_2$ ($f_2 > f_1$) dont l'amplitude est inférieure à l'amplitude de la déviation avec la fréquence $f_1$.

3. Procédé pour dévier un faisceau corpusculaire selon la revendication 2, caractérisé par le fait que la vitesse de déviation qui résulte de l'attaque avec la fréquence $f_1$ est égale et opposée à la vitesse de déviation qui est provoquée par la déviation électrostatique supplémentaire avec la fréquence $f_2$.

4. Dispositif pour la mise en œuvre du procédé selon les revendications 2 ou 3, avec des bobines de déflection comme dispositif de déviation magnétique et des plaques de condensateur comme dispositif de déviation électrostatique, caractérisé par le fait que les bobines de déflection (3, 3') sont reliées à un amplificateur de courant (11) et les plaques de condensateur (4, 4') sont reliées à un amplificateur de tension (12), que les deux amplificateurs (11, 12) sont reliés en commun à une sortie pour la fréquence $f_1$ d'un organe de commande (10), et que l'amplificateur de tension (12) est en outre relié à une seconde sortie pour la fréquence $f_2$ de l'organe de commande (10).

5. Dispositif selon la revendication 4, caractérisé par le fait que pour chaque coordonnée les champs des deux dispositifs de déviation (1, 2) ne sont pas exactement perpendiculaires entre eux.

FIG 1

FIG 2

FIG 3

FIG 4

FIG 5

FIG 6

FIG 7

$Wr = Wm + We_1 + We_2$